# EUROPEAN PATENT APPLICATION

(11) **EP 4 765 872 A1**
(43) Date of publication of application: **24.06.2026**
(21) Application number: 24222773.4
(22) Date of filing: 23.12.2024
(51) Int. Cl.: H04R 3/04, B60K 35/10, B60K 35/26, G06F 3/16, G06N 3/08, H03G 5/16, H04S 7/00

(54) **INTELLIGENT AUDIO PROCESSING SYSTEM**

(71) Applicant: Harman Becker Automotive Systems GmbH, 76307 Karlsbad (DE)
(72) Inventor: GOPAKUMAR, Sreejith, 76307 Karlsbad (DE); von TÜRCKHEIM, Friedrich, 76307 Karlsbad (DE)
(74) Representative: Westphal, Mussgnug & Partner, Patentanwälte mbB

(57) **Abstract**

A system is described that comprises a computing device comprising one or more processors and a memory. The computing device is configured to receive user input and to analyze the user input to generate control data. The computing device is further configured to analyze the audio input to generate signal data that are characteristic of the audio input and to analyze previous tuning data to generate reference data. The computing device is also configured to process at least the control data, the signal data, and reference data to generate tuning data. In addition, the computing device is configured to process audio input to generate audio output based on at least one audio model and the tuning data.

## Description

### TECHNICAL FIELD

Embodiments of the subject matter disclosed herein relate to the field of audio signal processing, and more particularly to an intelligent audio processing system and a method thereof.

### BACKGROUND

There is an increasing demand for an audio that is personalized and provides a satisfying listening experience. Many models are available that are able to simulate sources, rooms or a desired listening environment. However, in automobiles, each occupant has their own preferences and would like to interact and listen to the music in their own unique style. This can render an audio processing particularly complex. Further, the large number of necessary audio features requires a very high processing power.

In order to reduce the complexity of automotive audio systems, most audio models are pre-tuned and the end-user has very little possibility to influence the audio experience. Further, the acoustic tuning of the audio models, e.g. in listening rooms or cars, is usually done manually, which can be particularly time-consuming as the whole system (e.g. car, room etc.) has to be measured and tuned before tuning the corresponding audio models.

The inventors herein have recognized the aforementioned issues and developed a system and a method that at least partially address these issues, in particular an audio processing system that is able to provide a highly personalized listening experience, while keeping the processing power and the tuning time as low as possible.

### SUMMARY

The above-mentioned objective is achieved by the system of claim 1 and by the method of claim 12. The system as herein disclosed comprises a computing device that is able to tune and combine different kinds of audio models based on reference model tunings and end user control. Machine learning algorithms may also be used to increase the efficiency of the system and reduce the complexity of the tuning process. In particular, it is possible to at least partially dispense with manual tuning. With the proposed system, users are able to fine-tune the available audio models to their personal needs. The users are more involved with the audio tuning, which can improve the overall user's experience. The presented system is also particularly time- and energy-saving.

In one example, the disclosure is directed to a system that comprises a computing device having one or more processors and a memory. The computing device is configured to receive user input and to analyze the user input to generate control data. The computing device is also configured to analyze the audio input to generate signal data that are characteristic of the audio input and to analyze previous tuning data to generate reference data. The computing device is further configured to process at least the control data, the signal data, and the reference data to generate tuning data. The computing device is also configured to process audio input to generate audio output based on at least one audio model and the tuning data.

In one example, the disclosure is directed to a method that comprises the steps of receiving user input and analyzing the user input to generate control data. The method also comprises the step of analyzing the audio input to generate signal data that are characteristic of the audio input and of analyzing previous tuning data to generate reference data. The method further comprises the step of processing at least the control data, the signal data, and the reference data to generate tuning data. In addition, the method comprises the step of processing audio input to generate audio output based on at least one audio model and the tuning data.

### BRIEF DESCRIPTION OF THE DRAWINGS

The embodiments described herein can be better understood with reference to the following description and drawings. The components in the figures are not necessarily to scale, emphasis instead being placed upon illustrating the principles of the embodiments. Furthermore, in the figures, like reference numerals designate corresponding parts. In the drawings:
FIG. 1 schematically illustrates an example of an audio processing system in accordance with one or more techniques described herein.
FIG. 2 is a flowchart illustrating a method for a system according to one or more embodiments of the present disclosure.

### DETAILED DESCRIPTION

Many audio models are available to provide the listener with a more impressive and realistic musical experience. As an example, with so-called 3D up-mixing models, it is possible to simulate a special listening environment, such as a giant rock concert outdoors, a classical musical venue or a small café. The listener, who is listening to the audio in a room or in a car, has the impression to be "immersed" in the reproduced sound just as if the user were located in the actual listening environment. The 3D audio effect can be achieved with virtual sound by utilizing a multi-channel audio system consisting of multiple speakers to simulate the virtual source at supposed locations. Reverberation models are able to simulate the reverb effects and reflections in venues by adding reverb signals to the audio signal to emulate distant virtual sound sources, thereby improving the realism of the audio signal. Virtual source positioning models are able to virtually position a sound source as a virtual sound source relative to the user. Other audio models are able to transform the acoustics of a room, e.g., a car cabin, into the acoustics of another room. With this, the environment inside the car cabin can be transformed into an acoustic scene like a desired particular venue. All these audio models play a prominent role is delivering an elegant and personalized audio experience to the end user.

In conventional audio systems, the features of these audio model are pre-tuned. However, each listener has their own preferences and would like to interact and listen to the music in their own unique style.

The system and method thereof disclosed in this disclosure are able to efficiently tune and combine various audio models according to user preferences and signal characteristics, while keeping the complexity of the tuning process as low as possible.

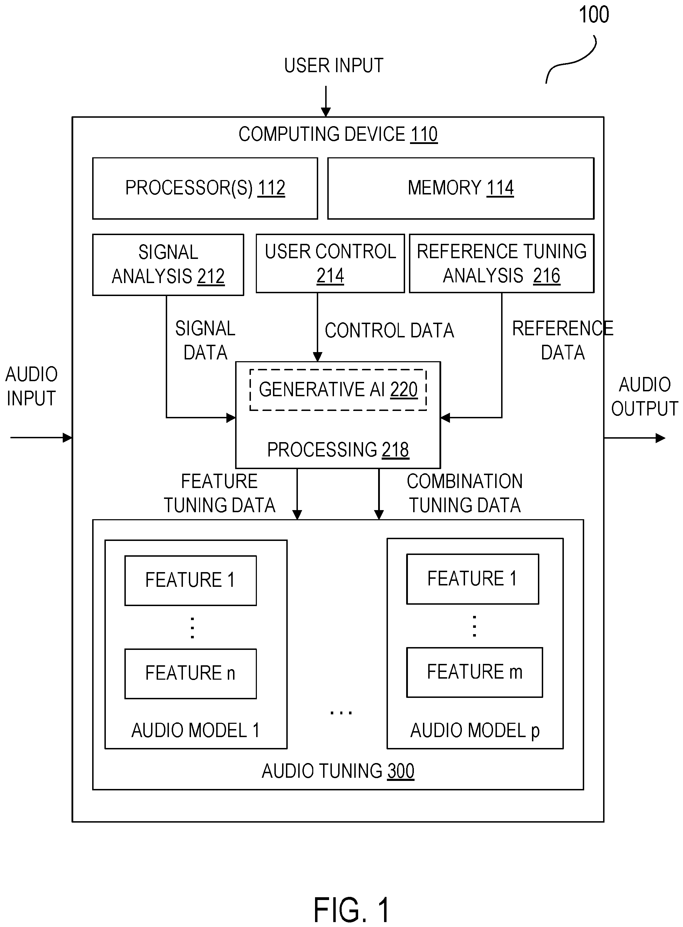

FIG. 1 schematically illustrates an audio processing system 100 in a block diagram. The system 100 comprises a computing device 110, the computing device 110 comprising one or more processors 112 and a memory 114. The computing device 110 is configured to receive user input and to analyze the user input to generate control data. The computing device 110 is also configured to analyze the audio input to generate signal data that are characteristic of the audio input and to analyze previous tuning data to generate reference data. The computing device 110 is further configured to process at least the control data, the signal data, and the reference data to generate tuning data. The computing device 110 is also configured to process audio input to generate audio output based on at least one audio model and the tuning data. With this, it is possible to tune features of the audio model based on user preferences and reference data. This makes it possible to personalize the listening experience and improve the user's experience. The system 100 may be connected to a multi-channel audio system that comprises a plurality of speakers that can output the audio output generated by the system 100. The audio input may be processed by means of at least one audio tuning algorithm 300.

Computing device 110 may be any kind of device that includes one or more processor(s) 112 such as a system-on-a-chip (SoC). In some embodiments, computing device 110 can be a head unit, an amplifier, or other component included in a vehicle system. Generally, computing device 110 may be configured to coordinate the overall operation of the system 100. The embodiments disclosed herein contemplate any technically-feasible system configured to implement the functionality of system 100 via computing device 110. In various embodiments, computing device 110 may be located in various environments including, without limitation, a vehicle environments such as, e.g., consumer vehicles, commercial vehicles, bicycles, motorcycles, wheeled drones; a private room such as, e.g., a living-room or a bedroom; or a public space such as, e.g., a movie theater.

Processor(s) 112 may be any technically-feasible form of processing device configured to process data and execute program code. Processor(s) 112 could include, for example and without limitation, a system-on-chip (SoC), a central processing unit (CPU), a graphics processing unit (GPU), an application specific integrated circuit (ASIC), a digital signal processor (DSP), a field programmable gate array (PFGA), and/or the like. Processor(s) 112 may include one or more processing cores. In operation, processor(s) 112 may be a primary processor of the computing device 110, controlling and coordinate operations of other system components. For example, processor(s) 112 may be configured to execute instructions (e.g., methods, algorithms, processes, etc.) stored in memory 114.

Memory 114 may include a memory module or a collection of memory modules. Memory 114 may be non-transitory memory or other form of non-volatile memory, random access memory (RAM), or any other feasible type of memory storage system. In various embodiments, memory 114 includes non-volatile memory, such as an optical drive, magnetic drive, flash drive, or other storage. In some embodiments, separate data stores, such as external data stores included in a network ("cloud storage") can supplement or constitute memory 114. In various embodiments, processor(s) 112 can execute instructions of various applications stored in the memory 114 to implement the overall functionality of the computing device 110 and, thus, to coordinate the operation of the system 100 as a whole, as will be seen below.

In one example, the computing device 110 comprises a user control application 214, which, when executed by the computing device 110, causes the computing device 110 to receive the user input and to analyze the user input to generate control data. The user control application 214 may be stored and loaded into the memory 114 for execution.

In one example, the computing device 110 is connected to a Human-Machine-Interface (HMI) and receives the user input via the HMI, for example via a screen or a keypad. For example, in a car, the driver may provide a user input via the dashboard and a back passenger may provide an input via a screen arranged on the back of a headrest. The user input indicates the user preferences for the audio tuning and may comprise at least one of: a desired origin of a perceived sound; a desired listening environment; a desired perceived position of the listener within an artificial sound event; a desired signal distribution of perceived audio; a desired position of the instruments and/or of the voice; a type of music; and desired ambience characteristics. For example, the user, who is sitting in a room or in a car, may want to listen to the audio content as though they were in a park or in a concert hall (desired listening environment). The type of music may be one of: classical music; jazz music; rock music, etc. The ambience characteristics describe the properties of the desired artificial space and may comprise at least one of: a width of the stage; a depth of the stage; and a level of reverb effect. In one example, the user may provide user input at any time. This makes it also possible for the user to provide a feedback on the audio content.

The user input is then analyzed by the user control application 214 to provide useful control data for a processing device 218 based on the user preferences. The control data may comprise desired values of parameters of features of one or several audio models. In one example, the user control application 214 maps a user preference, such as the nature of the desired ambience, to control data related to a specific audio model, such as the reverberation model.

The computing device 110 may be configured to analyze the user input at regular intervals. In one example, the intervals are determined by a clock generator of the computing device 110. In another example, the computing device 110 is configured to analyze the user input each time the user inputs new data. With this, the audio model can be tuned in a dynamic manner.

In one example, the computing device 110 comprises a reference tuning analysis device 216 that is configured to generate the reference data. The reference data are data related to previous audio tuning processes. In one example, the previous tuning data are stored in the computing device 100 and loaded into the reference tuning analysis device 216. In one example, the reference tuning analysis device 216 is configured to receive the previous tuning data from an external device, such as a cloud computing system. With this, it is possible to collect a large amount of data regarding previous audio tuning processes. The previous tuning data may comprise reference tuning data and reference measurement data. The reference tuning data may comprise tuning parameters previously used for tuning different audio models and the reference measurement data may be previously measured characteristics of different audio systems in different environments. In one example, the reference tuning data comprise tuning parameters for different features of various pre-tuned audio models which can be used as reference. In one example, the reference measurement data comprise impulse response measurements in different listening environments, such as in several cars, listening rooms etc. for different features of various pre-tuned audio models which can be used as reference. The data may be in any format, e.g..wav. In one example, the tuning analysis device 216 uses machine-learning algorithms that are trained with the reference tuning data and reference measurement data. The reference data generated by the machine-learning algorithm-based tuning analysis device 216 thus already contain the tuning dependencies between various rooms, audio models, features of audio models, etc. This allows the processing device 218 (which may also contain ML algorithms) to efficiently combine the reference data with the control data and the signal data to generate corresponding tuning data for the audio models and their features. The reference data generated by the reference tuning analysis device 216 may also be used as references to train machine learning models, as will be seen below.

In one example, the computing device 110 comprises a signal analysis application 212, which, when executed by the computing device 110, causes the computing device 110 to perform a signal analysis on the audio input and to generate the signal data. The signal analysis application 212 may comprise signal analysis algorithms, such as fast Fourier transform (FFT), finite impulse response (FIR) filter, and Infinite impulse response (IIR) filter. The signal analysis application 212 may be stored and loaded into the memory 114 for execution. In one example, the signal data comprise at least one or more of: a type of music; note onsets; and an audio texture. The type of music (genre) may be classical music, jazz music, rock music, etc. The note onset defines the beginning of a note or a sound. It may be obtained base on an analysis of the spectral energy distribution. The audio texture indicates a level of "thickness" of the audio content. The audio texture may one of: monophonic and polyphonic. Further signal data can also be defined if they are useful for tuning the audio model. In one example, the signal analysis is carried out with the help of machine learning algorithms, which have access to other signal data. This might be helpful to increase the performance of the signal analysis. With the above-defined signal analysis, the computing device 110 is able to extract meaningful features that can be used to tune the audio model.

The control data, the reference data and the signal data are then processed to generate the tuning data. The tuning data comprise tuning parameters for all the available audio models, tuning parameters of features of the audio models, and tuning parameters for combining different audio models and different features within the same audio model as well as between different audio models. The tuning data indicate which audio models should be used, how to combine the various available audio models and the various features of the audio models, and how to tune the features of the different audio models. In one example, the computing device 110 comprises a processing device 218, which, when executed by the computing device 110, causes the computing device 110 to process at least the control data, the tuning data and the signal data to generate the tuning data for the at least one audio model. The processing device 218 may be an application stored and loaded into the memory 114 for execution.

In one example, the processing device 218 is configured to apply one or more machine learning (ML) algorithms 220 to at least the control data, the reference data and the signal data to generate the tuning data. The ML algorithms 220 may be and loaded into the memory 114 for execution. In one example, the one or more ML algorithms 220 are trained using the reference data. The ML algorithms 220 can thus have access to a larger variety of data pertaining to different signals. This enables the ML algorithms 220 to understand the correlation between the tuning data and the sound signals. With the reference data, the ML algorithms 220 are also trained for a very large number of users. The ML algorithms 220 can thus understand how the user preferences can be mapped to the control data of a particular audio model, so that they can formulate efficient ways of combining different audio models or different features of different audio models based on the user preferences and the signal data. With this, it is possible to improve the quality and the efficiency of the processing. The tuning data may comprise feature tuning data, which indicate how to tune the features of the audio models, and combination tuning data, which indicate how to combine different audio models and different features of different audio models.

The computing device 110 comprises one or several audio models. In the depicted example, the computing device 110 comprises p audio models. Audio models may be one of the following: a 3D up-mixing model; a reverberation model; a virtual source positioning model; and a model able to transform the acoustics of a room into the acoustics of another room. These audio models have been described above. The audio models may be pre-stored. In one example, the audio models are stored in an audio tuning device 300. The audio tuning device 300 may be an application that is stored and loaded into the memory 114 for execution. The audio tuning device 300 may thus contain all the necessary audio models and may be responsible for processing the audio input. The audio tuning device 300 may select, tune and combine the audio models and their features based on the combination tuning data and the feature tuning data derived by the ML algorithms 220.

Each audio model may comprise a plurality of features that can be tuned. More specifically, the features may comprise various parameters that can be tuned. In the depicted example, the first audio model comprises n features and the p audio model comprises m features. In one example, the computing device 110 is configured to tune the parameters of the different features of the at least one audio model based on the tuning data. Specifically, the audio tuning device 300 may tune the features of the at least one audio model based on the feature tuning data. With this, the audio model can be tuned based on the user preferences.

In one example, the computing device 110 is further configured to select the at least one audio model from a plurality of available audio models based on the tuning data. In one example, the computing device 110 is configured to select at least one feature from the plurality of features of the different available audio models based on the tuning data. As mentioned above, the audio tuning device 300 may comprise a plurality of audio models, each audio model having a plurality of features. However, depending on the situation, only some of the available audio models or some of the available features may be relevant in order to obtain the desired listening experience. In particular, if the user has indicated that the music should be played quietly and outdoors, it might not be useful to add reverb effects. In this case, the audio tuning device 300 may block, based on the tuning data, the audio models and/or the features of the audio models that correspond to the reverb effects. In one example, the audio tuning device 300 sets the parameters of the corresponding audio models or features to zero. In another example, the audio tuning device 300 by-passes the unnecessary audio models or features. In a further example, the audio tuning device 300 reduces or cuts down the power for the unnecessary audio models or features. This makes it possible to reduce the complexity of the processing whenever possible. With this, the tuning processing can be particularly quick.

The audio models, as well as the features of the different audio models, may also be combined with each other. In one example, the computing device 110 is further configured to combine at least two audio models or at least two features of two different audio models based on the tuning data to obtain a combined audio model, and to generate audio output based on the combined audio model. For example, a specific feature from a first audio model may be combined with another feature from a second audio model that is different from the first audio model based on the combination tuning data. With this, it is possible to create a new audio model by combining features selected from different audio models. The selected features may then be tuned based on the feature tuning data. The audio tuning device 300 may combine the audio models and/or the features of different audio models based on the combination tuning data. With this, it is possible to provide an impressive and immersive listening environment which is fine-tuned to the user preferences.

In one example, when the end user indicates, via the user input, a preferred position of the instruments and the voice, the audio tuning device 300 combines an upmixing model and a virtual source positioning model. In another example, when the end user indicates, via the user input, a type of music and a desired listening environment (or room), the audio tuning device 300 combines an upmixing model and a model able to transform the acoustics of a room into the acoustics of another room. In a further example, when the end-user indicates, via the user input, a preferred simulated room and preferred moving sources, the audio tuning device 300 combines a models able to transform the acoustics of a room into the acoustics of another room and a virtual source positioning model.

The above examples show that user can have a strong influence on how the audio models and their features are combined. However, the audio input and the signal analysis of the audio input can also be very relevant for combining the audio models. In one example, the audio input is a football commentary. The signal analysis application 212 generates the signal data corresponding to this content. Based on the signal data, the audio tuning device 300 combines an upmixing model and an audio model transforming the acoustics of one room to another room to create the environment of a football stadium. The feature tuning data and the combination tuning data are derived using the signal data, the control data and the reference data. In another example, the signal data indicate that the audio input already has a lot of ambience (e.g. a lot of reverb effects). In this case, the audio tuning device 300 does not need to use the reverberation model to generate artificial reverb effects. However, if this is required by the user, the audio tuning device 300 can modify, based on the control data (user preferences), the parameters of the features of the reverberation model to generate more ambience. In a further example, the audio input is a navigation command for a vehicle. The signal analysis application 212 generates signal data corresponding to this information. The signal data cause the audio tuning device 300 to select the virtual source positioning model and to tune it so as to position audio output comprising the navigation command around the user based on the control data. In this scenario, other audio models, such as the reverberation model or the upmixing model, can be by-passed or are not processed at all.

The audio tuning device 300 may also combine different features of different audio models in order to obtain a desired audio model. The computing device 110 of the application thus offers the user the possibility to position the instruments and the voice, to enhance the ambience based on a type of music and a type of environment, or to experience an audio rendering with simulated rooms and moving sources, according to their preferences. In one example, the combination tuning data comprise weighting values for the different audio models or for the different features of the audio models. The weighting values may reflect the importance of the audio effect corresponding the audio model or to the feature in the eyes of the user as understood based on the user input. The audio tuning device 300 may then be configured to combine the audio models and/or the features of the audio models based on the weighting values. With this, it is possible to tune the audio models in a very simple and flexible manner, thereby reflecting the preferences of the user.

The above functions of the computing device 110 (and of the audio tuning device 300) may be combined with each other. In particular, the computing device 100 may be configured to select some of the available audio models or features, tune the remaining audio models or features and combine them with each other.

The system 100 of the application thus offers the user the possibility to fully tune an audio content according to their preferences. In particular, the user may choose a type of music, an environment, a position, and the computing device 110 will process the audio input accordingly. The user has thus the possibility to interact with the audio content and to fine-tune the audio rendering with a high degree of freedom. This may enhance the user engagement with the music processing and, thus improve the user's experience. With the proposed system, an authentic and unique personalized audio can be delivered. The additional use of machine learning algorithms, as well as the possibility to efficiently combine different audio models and different features of different audio models, can significantly simplify the tuning process. In addition, since unused audio models and features may be powered down, the overall processing power may be reduced.

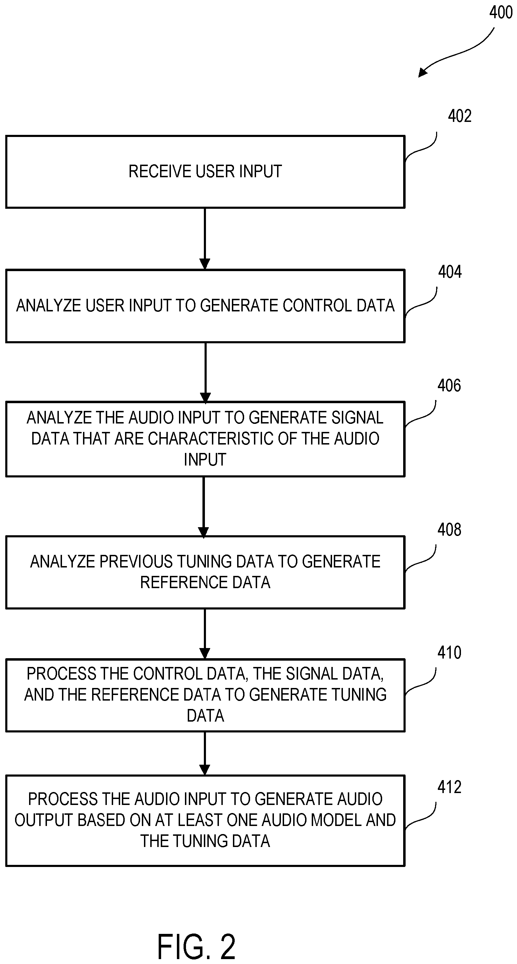

Turning now to FIG. 2, a flowchart illustrating a method 400 for an audio processing system, such as the system 100 of FIG. 1, is shown. The method 400 may be executed by one or more processors of the system 100, such as processor(s) 112, based on instructions stored in memory, such as memory 114.

At 402, method 400 includes receiving user input. The user input may be provided by a user via a Human-Machine-Interface (HMI). The user input may comprise at least one of: a desired origin of a perceived sound; a desired listening environment; a desired perceived position of the listener within an artificial sound event; a desired signal distribution of perceived audio; a desired position of the instruments and/or of the voice; a type of music; and desired ambience characteristics. With the user input, the user indicates their audio preferences. In particular, the user can indicate a preferred listening environment (e.g. concert hall, café, outdoors) and the exact properties of this listening environment. The user can also indicate preferred music parameters (e.g. position of the instruments, type of music). These input data will then be used to process the audio input, in particular to tune and combine audio models. In one example, the user chooses the input data out of a predetermined list of parameters. In another example, the user may freely provide a user input with their own words. This user input may then be processed by machine learning algorithms to extract the relevant data for the audio processing.

At 404, method 400 includes analyzing user input to generate control data. The control data may indicate target values for the audio processing, in particular for parameters of audio models used for the audio processing. User preferences, as set out in the user input, may be mapped to control data. In one example, the control data are generated with the help of a look-up table which associates user input to control data. In another example, the control data are generated with the help of one or several machine learning algorithms. These machine learning algorithms may have access to previous control data, which may simplify the generation of the control data. The control data may then be fed to a machine learning model that outputs tuning data for the audio processing. With this, the audio input may be processed based on the user preference, thus providing a highly personalized sound.

At 406, method 400 includes analyzing the audio input to generate signal data that are characteristic of the audio input. In one example, a digital signal analysis is carried out on the input signal. In one example, the signal data comprise at least one or more of: a type of music; note onsets; and an audio texture. With this, it is possible to extract useful features that can be fed to the machine learning model that processes the control data. The tuning data generated by the machine learning model can be better adapted to the audio input, resulting in a more efficient tuning.

At 408, method 400 includes analyzing previous tuning data and generating reference data based on the analyzed previous tuning data. The previous tuning data may be collected via an external server accessible via the Internet. In another example, the previous tuning data may be stored in a memory of a computing device that performs the method 400. The previous tuning data may comprise reference tuning data and reference measurement data. The reference tuning data may comprise tuning parameters previously used for tuning different audio models and the reference measurement data may be previously measured characteristics of different audio systems in different environments. In one example, the reference tuning data comprise tuning parameters for different features of various pre-tuned audio models which can be used as reference. In one example, the reference measurement data comprise impulse response measurements in different listening environments, such as in several cars, listening rooms etc. for different features of various pre-tuned audio models which can be used as reference.

At 410, method 400 includes processing at least the control data, the signal data, and the reference data to generate tuning data. Processing the control data, the signal data, and the reference data may be done with the help of one or several machine learning algorithms. The reference data may be used to train machine learning (ML) algorithms to establish connections between the user preferences, the signal data, and the tuning data. In particular, the machine learning algorithms may be trained with a large chunk of previous tuning data, a large variety of audio signals, and large number of users. This can reduce the tuning time and the complexity of the overall tuning process. The tuning data may comprise feature tuning data that are used to tune features of the audio models, and combination tuning data that are used to combine audio models with each other.

At 412, method 400 includes processing audio input to generate audio output based on at least one audio model and the tuning data. Each audio model corresponds to a particular audio technology. The audio processing model may be one of the following: a 3D up-mixing model; a reverberation model; a virtual source positioning model; and an audio model able to transform the acoustics of a room into the acoustics of another room. Each audio model comprises a plurality of features that can be tuned using the feature tuning data.

The feature tuning data and the combination tuning data computed by the ML algorithm may be used to select, tune and combine the audio models, as well as features of different audio models, so as to render an audio output based on the user preferences, the signal data, and the reference data. In one example, the audio models and/or the features of the audio models are selected based on the tuning data. The unselected audio models or features may be by-passed or put in a power-down mode, so that they are not used during audio processing. With this, only relevant audio models or relevant features are considered, which helps reduce the overall complexity of the audio processing. In one example, the features of the audio models are tuned based on the tuning data, in particular the feature tuning data. In one example, the audio models and the features of the audio models are combined based on the tuning data, in particular the combination tuning data. The combination tuning data may comprise weighting values associated to the audio models and to the features of the audio models. These weighting values may be used in the audio processing to take into account the importance of each audio model. This gives more flexibility in the combination process and can correspond better to the user's expectations. A weighting value of zero may lead to a deselection of the corresponding audio model or feature.

The method can be implemented by a computer. In particular, a computer-readable storage medium can comprise computer-executable instructions which, when executed by the computer, cause the computer to perform the method 400 of FIG. 2.

The present application describes a system and a method configured to process an audio input based on user preferences. The system comprises a computing device configured to generate control data based on a user input that indicates the preference of the user for the audio processing, in particular the preferred listening environment and the preferred way the sound should be output. The computing device is further configured to process the control data, signal data that are characteristic of the audio input, and reference data that correspond to previous measurements and previous tuning data, and to generate tuning data. The tuning data are used to tune and combine audio models that correspond to different audio technologies, as well as features of the audio models. The audio input is then processed via the tuned audio models to generate an audio output. Audio models can thus be tuned and combined in a personalized manner based on input audio analysis, tuning data analysis and end user preferences. With this, it is possible to generate an audio output that is customized to the user's preferences. In addition, machine learning algorithms may be used to render the audio processing more efficient. The machine learning algorithms may be trained by the reference data. With this, it is possible to further reduce the complexity of the audio processing and of the tuning process. The system can take into account a large variety of data from various users, various systems and various audio signals, to provide an audio output that is satisfying to the user. The user may continuously input new input data, thus contributing to the enhanced performance of the audio system. With the proposed system, it is possible to provide an authentic and unique personalized audio experience for the end user. In particular, the user can be strongly involved in the fine-tuning of the audio rendering system, which can be extremely satisfying to the user. Tuning and combining audio models and their features with the help of machine learning algorithms can simplify the tuning process, in particular by getting rid of the manual tuning effort, and enhance the user's listening experience. With this, it is possible to save time and money and to reduce the complexity of the tuning process. By selecting only useful audio models or features and efficiently combining the remaining audio models or features, multiple audio models can co-exist within the system, while keeping the processing power as low as possible.

Although various embodiments have been illustrated and described with respect to one or more specific implementations, alterations and/or modifications may be made to the illustrated examples without departing from the spirit and scope of the features and structures recited herein. With particular regard to the various functions performed by the above described components or structures (units, assemblies, devices, circuits, systems, etc.), the terms (including a reference to a "means") used to describe such components are intended to correspond - unless otherwise indicated - to any component or structure that performs the specified function of the described component (e.g., that is functionally equivalent), even if it is not structurally equivalent to the disclosed structure that performs the function in the herein illustrated exemplary implementations of the present disclosure.

The following claims particularly point out certain combinations and sub-combinations regarded as novel and non-obvious. These claims may refer to "an" element or "a first" element or the equivalent thereof. Such claims should be understood to include incorporation of one or more such elements, neither requiring nor excluding two or more such elements. Other combinations and sub-combinations of the disclosed features, functions, elements, and/or properties may be claimed through amendment of the present claims or through presentation of new claims in this or a related application. Such claims, whether broader, narrower, equal, or different in scope to the original claims, also are regarded as included within the subject matter of the present disclosure.

## Claims

1. A system (100), comprising:
a computing device (110) comprising one or more processors (112) and a memory (114), wherein the computing device (110) is configured to:
receive user input;
analyze the user input to generate control data;
analyze the audio input to generate signal data that are characteristic of the audio input;
analyze previous tuning data to generate reference data;
process at least the control data, the signal data, and the reference data to generate tuning data; and
process audio input to generate audio output based on at least one audio model and the tuning data.

2. The system (100) of claim 1, wherein
the audio input is processed by means of at least one audio tuning algorithm (300).

3. The system (100) of claim 1, wherein
the at least one audio model is pre-stored.

4. The system (100) of any one of claims 1 to 3, wherein
the computing device (110) is further configured to tune features of the at least one audio model based on the tuning data.

5. The system (100) of any one of claims 1 to 4, wherein
the computing device (110) is further configured to select the at least one audio model from a plurality of available audio models based on the tuning data.

6. The system (100) of any one of claims 1 to 5, wherein
the computing device (110) is further configured to:
combine at least two audio models or at least two features of two different audio models based on the tuning data to obtain a combined audio model, and
generate audio output based on the combined audio model.

7. The system (100) of any one of claims 1 to 6, wherein
the computing device (110) is further configured to apply one or more machine learning (ML) algorithms to at least the control data, the signal data, and the reference data to generate the tuning data.

8. The system (100) of claim 7, wherein
the one or more ML algorithms are trained using the reference data.

9. The system (100) of any one of claims 1 to 8, wherein
the previous tuning data comprise reference tuning data and reference measurement data, wherein the reference tuning data comprise tuning parameters previously used for tuning different audio models and the reference measurement data are previously measured characteristics of different audio systems in different environments.

10. The system (100) of any one of claims 1 to 9, wherein
the signal data comprise at least one or more of: a type of music; note onsets; and an audio texture.

11. The system (100) of any one of claims 1 to 10, wherein
the user input comprises at least one of: a desired origin of a perceived sound; a desired listening environment; a desired perceived position of the listener within an artificial sound event; a desired signal distribution of perceived audio; a desired position of the instruments; a desired position of the voice; a type of music; and desired ambience characteristics.

12. A method, comprising:
receiving user input;
analyzing the user input to generate control data;
analyzing the audio input to generate signal data that are characteristic of the audio input;
analyzing previous tuning data to generate reference data;
processing at least the control data, the signal data, and the reference data to generate tuning data; and
processing audio input to generate audio output based on at least one audio model and the tuning data.

13. A computer-readable storage medium comprising computer-executable instructions which, when executed by a computer, cause the computer to perform the method according to claim 12.
